# EUROPEAN PATENT SPECIFICATION

(11) **EP 4 266 358 B1**
(45) Date of publication and mention of the grant of the patent: **06.05.2026**
(21) Application number: 23153813.3
(22) Date of filing: 27.01.2023
(51) Int. Cl.: H10D 30/67, H10D 84/01, H10D 84/03, H10D 84/83, H10W 20/00, H10W 20/42, H10D 30/01, H10D 30/43, H10D 62/10, H10D 62/13, H10D 64/01, H10D 64/23

(54) **SEMICONDUCTOR DEVICE**
HALBLEITERANORDNUNG
DISPOSITIF SEMI-CONDUCTEUR

(30) Priority: 18.04.2022 KR 20220047647
(43) Date of publication of application: 25.10.2023
(73) Proprietor: Samsung Electronics Co., Ltd., Gyeonggi-do 16677 (KR)
(72) Inventor: LEE, Doohyun, 16677 Suwon-si (KR); SHIN, Heonjong, 16677 Suwon-si (KR); KIM, Seonbae, 16677 Suwon-si (KR); PARK, Jinyoung, 16677 Suwon-si (KR); PARK, Hyunho, 16677 Suwon-si (KR); YU, Jimin, 16677 Suwon-si (KR); JANG, Jaeran, 16677 Suwon-si (KR)
(74) Representative: Marks & Clerk LLP

(56) References cited:
- US-A1- 2020 105 603
- US-A1- 2020 119 180
- US-B1- 10 121 702

## Description

### BACKGROUND

Example embodiments of the disclosure relate to a semiconductor device.

As the demand for high performance, high speed, and/or multifunctionality of a semiconductor device has increased, integration density of a semiconductor device has also increased. In manufacturing a semiconductor device having a fine pattern corresponding to the trend of high integration of the semiconductor device, it has been necessary to implement patterns having a fine width or a fine spacing. Also, to address the limitations of operation properties due to the size reduction of a planar metal oxide semiconductor FET (MOSFET), there have been attempts to develop a semiconductor device including a FinFET having a three-dimensional channel structure.

US 2020/105603 A1, US 2020/119180 A1 and US 10,121,702 B1 describe related semiconductor devices.

### SUMMARY

The invention provides a semiconductor device as set out in the accompanying claims.

### BRIEF DESCRIPTION OF DRAWINGS

The above and other aspects, features, and advantages of certain embodiments of the disclosure will be more apparent from the following detailed description, taken in combination with the accompanying drawings, in which:
FIG. 1 is a plan diagram illustrating a semiconductor device according to an example embodiment;
FIGS. 2A to 2C are cross-sectional diagrams illustrating a semiconductor device according to an example embodiment;
FIG. 3 is a cross-sectional diagram illustrating a semiconductor device according to an example embodiment;
FIG. 4 is a cross-sectional diagram illustrating a semiconductor device according to an example embodiment;
FIG. 5 is a cross-sectional diagram illustrating a semiconductor device according to an example embodiment;
FIG. 6 is a cross-sectional diagram illustrating a semiconductor device according to an example embodiment;
FIGS. 7A and 7B are cross-sectional diagrams illustrating a semiconductor device according to an example embodiment;
FIG. 8 is a plan diagram illustrating a semiconductor device according to an example embodiment; and
FIGS. 9A to 9C, 10A, 10B, 11A, 11B, 12A, 12B, 13A, and 13B are diagrams illustrating processes of a method of manufacturing a semiconductor device according to an example embodiment.

### DETAILED DESCRIPTION

Hereinafter, embodiments of the disclosure will be described as follows with reference to the accompanying drawings.

It will be understood that when an element or layer is referred to as being "over," "above," "on," "below," "under," "beneath," "connected to" or "coupled to" another element or layer, it can be directly over, above, on, below, under, beneath, connected or coupled to the other element or layer or intervening elements or layers may be present. In contrast, when an element is referred to as being "directly over," "directly above," "directly on," "directly below," "directly under," "directly beneath," "directly connected to" or "directly coupled to" another element or layer, there are no intervening elements or layers present. Like numerals refer to like elements throughout.

Spatially relative terms, such as "over," "above," "on," "upper," "below," "under," "beneath," "lower," and the like, may be used herein for ease of description to describe one element's or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the term "below" can encompass both an orientation of above and below. The device may be otherwise oriented (rotated 90 degrees or at other orientations) and the spatially relative descriptors used herein interpreted accordingly.

For the sake of brevity, conventional elements to semiconductor devices may or may not be described in detail herein for brevity purposes.

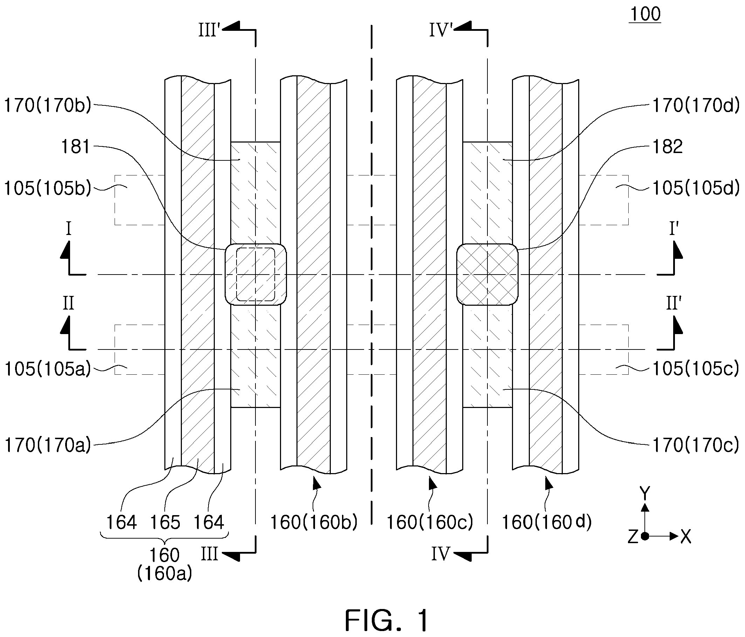

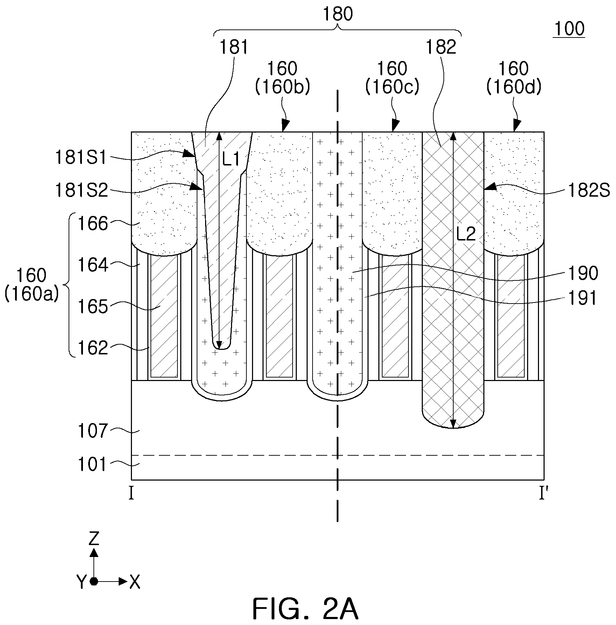

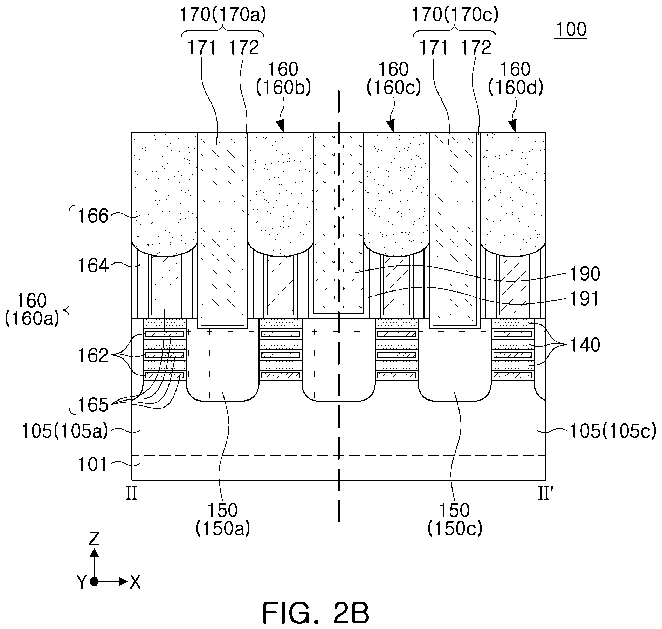

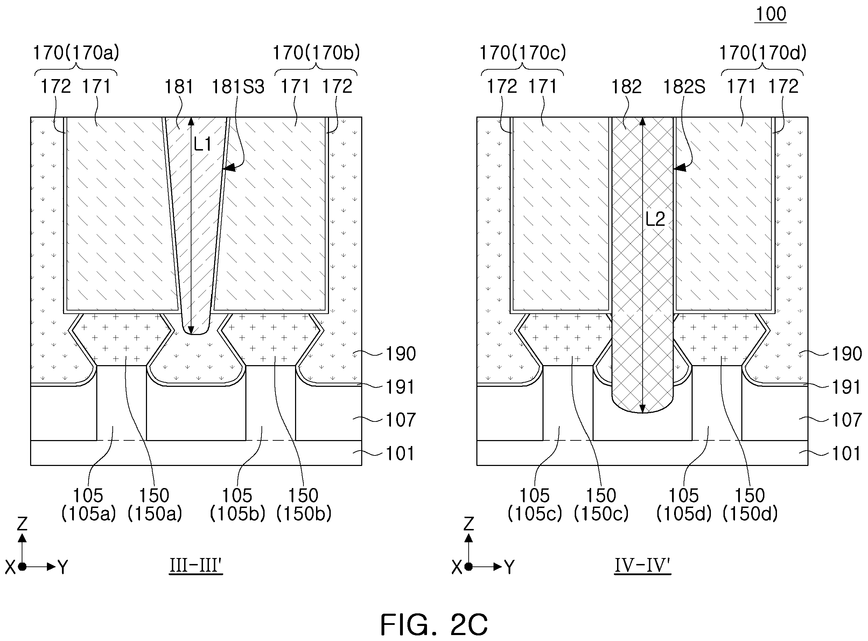

FIG. 1 is a plan diagram illustrating a semiconductor device 100 according to an example embodiment. FIGS. 2A and 2C are cross-sectional diagrams illustrating a semiconductor device 100 according to an example embodiment. FIG. 2A is a cross-sectional diagram illustrating a semiconductor device 100 taken along line I-I' in FIG. 1, FIG. 2B is a cross-sectional diagram illustrating a semiconductor device 100 taken along line II-II' in FIG. 1, and FIG. 2C is a cross-sectional diagram illustrating a semiconductor device 100 taken along line III-III' in FIG. 1. Only main components of the semiconductor device are illustrated in FIGS. 1 to 2C for ease of description.

Referring to FIGS. 1 to 2C, the semiconductor device 100 may include a substrate 101, active regions 105 on the substrate 101, device isolation layers 107 isolating the active regions 105 from each other, a plurality of channel layers 140 disposed on the active regions 105, source/drain regions 150 in contact with the channel layers 140, gate structures 160 extending by intersecting the active regions 105, contact plugs 170, isolation insulating patterns 180, and an interlayer insulating layer 190.

In an example embodiment, in the semiconductor device 100, the active regions 105 may have a fin structure, and the gate electrode 165 may be disposed between the active regions 105 and the channel layers 140, between the channel layers 140, and in an upper portion of the channel layers 140. Accordingly, the semiconductor device 100 may be configured as a transistor having a multi-bridge channel FET (MBCFET^{™}) structure, which may be a gate-all-around (GAA) field effect transistor formed by the channel layers 140, the source/drain regions 150, and the gate structures 160.

However, differently from the aforementioned example embodiments, the semiconductor device 100 may be implemented as a fin-type field effect transistor (FinFET) in which the active regions 105 may have a fin structure, the channel layers 140 may not be included, and a physical channel region of the transistor may be formed in an upper region of each of the active regions 105 intersecting the gate electrode 165. In this case, the gate electrode 165 may extend to cover the upper and side surfaces of each of the active regions 105.

The substrate 101 may have an upper surface extending in the x-direction and the y direction. The substrate 101 may include a semiconductor material, such as, for example, a group IV semiconductor, a group III-V compound semiconductor, or a group II-VI compound semiconductor. For example, the group IV semiconductor may include silicon, germanium, or silicon-germanium. The substrate 101 may be provided as a bulk wafer, an epitaxial layer, a silicon on insulator (SOI) layer, a semiconductor on insulator (SeOI) layer, or the like.

The active regions 105 may be disposed to extend in a direction parallel to the upper surface of the substrate 101, that is, for example, in the x direction. The active regions 105 may be spaced apart from each other in the y direction and disposed in parallel to each other (see, e.g., FIGS. 2B and 2C). The active regions 105 may protrude from the upper surface of the substrate 101 in the z-direction, a perpendicular direction. The upper ends of the active regions 105 may be disposed to protrude to a predetermined level from the upper surface of device isolation layers 107. The active regions 105 may be formed as a portion of the substrate 101, or may include an epitaxial layer grown from the substrate 101. However, the active regions 105 on the substrate 101 may be partially recessed on both sides of the gate structures 160, and the source/drain regions 150 may be disposed on the recessed active regions 105.

The active regions 105 include first to fourth active regions 105a and 105b, 105c, and 105d. Each of the first active region 105a and the second active region 105b may have a line shape or a bar shape extending in the first horizontal direction (e.g., the x direction). The first active region 105a and the second active region 105b are spaced apart from each other in a second horizontal direction (e.g., the y direction) and may extend in parallel to each other. Each of the third active region 105c and the fourth active region 105d may have a line shape or a bar shape extending in the first horizontal direction (e.g., the x direction). The third active region 105c and the fourth active region 105d are spaced apart from each other in the second horizontal direction (e.g., the y direction) and may extend in parallel to each other.

The device isolation layers 107 may define active regions 105 in the substrate 101. The device isolation layers 107 may be disposed between adjacent ones of the active regions 105. The device isolation layers 107 may have upper portions on a level lower than a level of the upper portions of the active regions 105. Accordingly, the device isolation layers 107 may partially expose the upper portions of the active regions 105. **In** an example embodiment, the device isolation layers 107 may have a curved upper surface having a level increasing toward the active regions 105, but an example embodiment thereof is not limited thereto. The device isolation layers 107 may be formed by, for example, a shallow trench isolation (STI) process. The device isolation layers 107 may be formed of an insulating material. The device isolation layers 107 may be, for example, oxide, nitride, or a combination thereof.

As illustrated in FIG. 2B, the channel layers 140 may be stacked and spaced apart from each other in the z direction perpendicular to the upper surface of the substrate 101 on the active regions 105. The channel layers 140 may be connected to the source/drain regions 150 and may be spaced apart from the upper surfaces of the active regions 105. The channel layers 140 may have the same width as or a similar width to that of the active regions 105 in the y direction, and may have the same width as or a similar width to that of the gate structures 160 in the x-direction. Three channel layers 140 are illustrated in the diagram (e.g., FIG. 2B), but the number of channel layers is not limited thereto and may be varied. For example, in example embodiments, the channel layers 140 may further include a channel layer disposed on the upper surface of the active regions 105. The channel layers 140 may be formed of a semiconductor material, and may include, for example, at least one of silicon (Si), silicon germanium (SiGe), and germanium (Ge). The channel layers 140 may include the same material, or may include different materials in example embodiments.

The source/drain regions 150 may be disposed on the active regions 105 on at least one side of the channel layers 140. The source/drain regions 150 may be disposed to cover upper surfaces of the active regions 105 on a side surface of each of the channel layers 140 and on a lower end of the source/drain regions 150. **In** other words, the source/drain regions 150 may be disposed to cover upper surfaces of the active regions 105 and side surfaces of the channel layers 140. The source/drain regions 150 may be in contact with the channel layers 140. The source/drain regions 150 may be partially recessed into the upper portions of the active regions 105, but in example embodiments, the presence of the recess and the depth of the recess may be varied. The source/drain regions 150 may be a semiconductor layer including silicon (Si), and may include an epitaxial layer.

Each of the source/drain regions 150 may include impurities of different types and/or concentrations.

The source/drain regions 150 include a first source/drain region 150a disposed on the first active region 105a, a second source/drain region 150b disposed on the second active region 105b, a third source/drain region 150c disposed on the third active region 105c, and a fourth source/drain region 150d disposed on the fourth active region 105d.

The gate structures 160 may intersect the active regions 105 and the channel layers 140 when viewed in a plan view, and may extend in one direction, that is, for example, the y direction. The gate structures 160 may be spaced apart from each other. Channel regions of transistors may be formed in the active regions 105 and/or the channel layers 140 intersecting the gate structures 160.

Each of the gate structures 160 may include a gate dielectric layer 162, a gate electrode 165, a spacer structure 164, and a capping layer 166. The gate structures 160 may be in contact with the channel layers 140 between the channel layers 140.

The gate dielectric layer 162 may be disposed between each of the active regions 105 and the gate electrode 165 and between the channel layers 140 and the gate electrode 165, and may cover at least a portion of the surfaces of the gate electrode 165. For example, the gate dielectric layer 162 may be disposed to surround the entirety of surfaces of the gate electrode 165 other than the uppermost upper surface of the gate electrode 165. The gate dielectric layer 162 may extend to a region between the gate electrode 165 and the spacer structure 164, but an example embodiment thereof is not limited thereto. The gate dielectric layer 162 may include an oxide, nitride, or high-k material. The high-k material may refer to a dielectric material having a dielectric constant higher than that of a silicon oxide layer (SiO₂). The high-k material may refer to a dielectric material having a dielectric constant higher than that of a silicon oxide layer (SiO₂). The high dielectric constant material may be one of aluminum oxide (Al₂O₃), tantalum oxide (Ta₂O₃), titanium oxide (TiO₂), yttrium oxide (Y₂O₃), zirconium oxide (ZrO₂), zirconium silicon oxide (ZrSiₓO_{y}), hafnium oxide (HfO₂), hafnium silicon oxide (HfSiₓO_{y}), lanthanum oxide (La₂O₃), lanthanum aluminum oxide (LaAlₓO_{y}), lanthanum hafnium oxide (LaHfₓO_{y}), hafnium aluminum oxide (HfAlₓO_{y}), and praseodymium oxide (Pr₂O₃). In example embodiments, the gate dielectric layer 162 may include multiple layers.

The gate electrode 165 may fill a gap between the channel layers 140 on the active regions 105 and may extend to an upper portion of the channel layers 140. The gate electrode 165 may be spaced apart from the channel layers 140 by the gate dielectric layer 162. The gate electrode 165 may include a conductive material, such as, for example, a metal nitride such as titanium nitride (TiN), tantalum nitride (TaN), or tungsten nitride (WN), and/or a metal material such as aluminum (Al), tungsten (W), or molybdenum (Mo), or a semiconductor material such as doped polysilicon. In example embodiments, the gate electrode 165 may include multiple layers, two or more layers. Depending on the configuration of the semiconductor device 100, the gate electrode 165 may be isolated by a separator between at least a portion of the transistors adjacent to each other. The gate electrode 165 may include different materials depending on transistor regions.

The spacer structure 164 may be disposed on both sidewalls of the gate electrode 165 and may extend in the z-direction perpendicular to the upper surface of the substrate 101. The spacer structures 164 may include a portion in which a width of the upper portion is smaller than a width of the lower portion. The spacer structure 164 may include a curved upper surface, curved toward the substrate 101. However, the shape of the spacer structure 164 may be varied in example embodiments. The spacer structure 164 may insulate the source/drain regions 150 from the gate electrode 165. The spacer structure 164 may include multiple layers in example embodiments. The spacer structure 164 may be formed of oxide, nitride, and oxynitride.

The capping layer 166 may be disposed on the gate electrode 165. The capping layer 166 may be a structure for protecting the gate electrode 165 from etching in a subsequent process after forming the gate electrode 165. The capping layer 166 may be a structure supporting the contact plugs 170 to be self-aligned during the process of forming a contact plug. However, the example embodiment of the capping layer 166 is not limited thereto.

The capping layer 166 may be disposed on the gate electrode 165 and the spacer structure 164, and at least a portion of the lower surface thereof may be surrounded by the gate electrode 165 and the spacer structure 164. In an example embodiment, the capping layer 166 may include a lower surface having a curved shape, convexly curved toward the substrate 101. The capping layer 166 may include silicon nitride or a silicon nitride-based insulating material.

The gate structures 160 include first and second gate structures 160a and 160b intersecting the first and second active regions 105a and 105b, and spaced apart from each other. The first and second gate structuress 160a and 160b may extend parallel to each other. The gate structures 160 further include third and fourth gate structures 160c and 160d intersecting the third and fourth active regions 105c and 105d, and spaced apart from each other. The third and fourth gate structures 160c and 160d may extend parallel to each other.

In an example embodiment, referring to FIG. 2C, the first source/drain region 150a may be disposed on the first active region 105a between the first and second gate structures 160a and 160b, and the second source drain region 150b may be disposed on the second active region 105b between the first and second gate structures 160a and 160b. Also, the third source/drain region 150c may be disposed on the third active region 105c between the third and fourth gate structures 160c and 160d, and the fourth source/drain region 150d may be disposed on the fourth active region 105d between the third and fourth gate structures 160c and 160d.

In an example embodiment, the semiconductor device 100 may further include internal spacer layers disposed in parallel to the gate electrode 165 between the channel layers 140. The internal spacer layers may be disposed on the same level as a level of the channel layers 140. The gate electrode 165 disposed below the uppermost portion of the channel layers 140 may be spaced apart from the source/drain regions 150 by the internal spacer layers and may be electrically isolated from the source/drain regions 150. The internal spacer layers may have a shape in which side surfaces opposing the gate electrode 165 have a rounded shape, rounded inwardly toward the gate electrode 165, but an example embodiment thereof is not limited thereto. The internal spacer layers may be formed of oxide, nitride, or oxynitride, and may be formed as a low-k film in particular. According to an example embodiment, as illustrated in FIG. 2B, the internal spacer layers may not be provided.

The contact plugs 170 may penetrate through interlayer insulating layer 190 and may be connected to the source/drain regions 150. The contact plugs 170 may apply electrical signals to the source/drain regions 150.

Each of the contact plugs 170 may have an inclined side surface of which a width decreases in a direction toward the substrate 101 depending on an aspect ratio, but an example embodiment thereof is not limited thereto. Each of the contact plugs 170 may be recessed from the source/drain regions 150 by a predetermined depth. However, in example embodiments, the contact plugs 170 may be in contact with the upper surfaces of the source/drain regions 150 without being recessed into the source/drain regions 150.

The contact plugs 170 may extend toward the source/drain regions 150 between the adjacent gate structures 160 and may be in contact with the source/drain regions 150.

In an example embodiment, the contact plugs 170 may be configured as self-aligning contacts (SAC) aligned by the gate structures 160. In this case, the contact plugs 170 may be aligned by the capping layer 166 of the adjacent gate structures 160. Alternatively, the contact plugs 170 may be formed using a separate mask.

The contact plugs 170 may include a plug layer 171 and a barrier layer 172. The plug layer 171 may include metal nitride such as titanium nitride (TiN), tantalum nitride (TaN), or tungsten nitride (WN), and/or a metal material such as aluminum (Al), tungsten (W), or molybdenum (Mo), for example. The barrier layer 172 may conformally cover side surfaces and a bottom surface of the plug layer 171. The barrier layer 172 may include, for example, a metal nitride such as a titanium nitride layer (TiN), a tantalum nitride layer (TaN), or a tungsten nitride layer (WN). The barrier layer 172 may allow the plug layer 171 and the isolation insulating patterns 180 to be apart from each other. The barrier layer 172 may extend along one side surface of the isolation insulating patterns 180 between the plug layer 171 and the isolation insulating patterns 180.

The contact plugs 170 include a first contact plug 170a connected to the first source/drain region 150a, a second contact plug 170b connected to the second source/drain region 150b, a third contact plug 170c connected to the third source/drain region 150c, and a fourth contact plug 170d connected to the fourth source/drain region 150d. The first to fourth contact plugs 170a, 170b, 170c, and 170d may be spaced apart from each other.

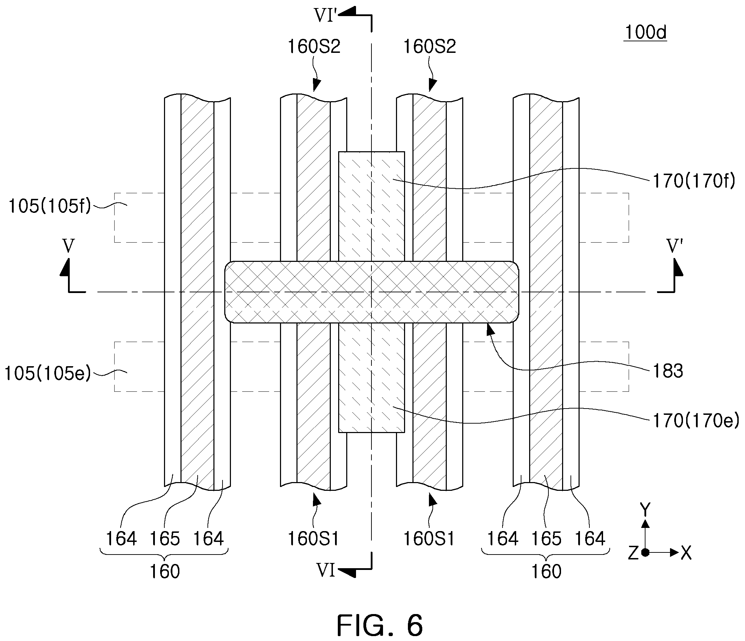

Each of the isolation insulating patterns 180 may isolate contact plugs 170 adjacent to each other in one direction (e.g., the y direction as shown in FIG. 1). The isolation insulating patterns 180 may be disposed in a hole shape between gate structures 160 adjacent to each other. The hole shape may have various shapes such as a square, a rectangle, a circle, and a polygon having rounded corners on a plane. Also, as illustrated in FIGS. 6 to 8, a portion of the isolation insulating patterns 180 may have various shapes, such as a line shape or a dam shape surrounding a specific closed space.

The isolation insulating patterns 180 may include an insulating material such as oxide, nitride, or carbide, and may include, for example, silicon nitride. **In** an example embodiment, each of the isolation insulating patterns 180 may be a single insulating material layer, but an example embodiment thereof is not limited thereto, and the isolation insulating patterns 180 may have a multilayer structure.

The isolation insulating patterns 180 include a first isolation insulating pattern 181 isolating the first contact plug 170a from the second contact plug 170b, and a second isolation insulating pattern 182 isolating the third contact plug 170c from the fourth contact plug 170d. The first isolation insulating pattern 181 may be in contact with each of the first and second contact plugs 170a and 170b between the first and second contact plugs 170a and 170b, and the second isolation insulating pattern 182 may be in contact with the third and fourth contact plugs 170c and 170d between the third and fourth contact plugs 170c and 170d, respectively.

In an example embodiment, side surfaces of the first and second isolation insulating patterns 181 and 182 may be in contact with the gate structures 160 in a first horizontal direction (e.g., the x direction), and may be in contact with the contact plugs 170 in the second horizontal direction (e.g., a y direction).

A side surface of the first isolation insulating pattern 181 and a side surface of the second isolation insulating pattern 182 may have different shapes.

In an example embodiment, the first isolation insulating pattern 181 may have an inclined side surface of which a width may decrease in a direction toward the substrate 101. The side surface of the first isolation insulating pattern 181 may have a plurality of side surfaces including a first side surface 181S1 having a first slope in the first horizontal direction and a second side surface 181S2 having a second slope in the first horizontal direction greater than the first slope. For example, the first side surface 181S1 and the second side surface 181S2 may have different slopes. A side surface of the first isolation insulating pattern 181 may have a third side surface 181S3 having a third slope in the second horizontal direction, as illustrated in FIG. 2C. However, the shape of the side surface of the first isolation insulating pattern 181 is not limited thereto and may be varied.

In an example embodiment, referring to FIG. 2C, the first and second contact plugs 170a and 170b may have a width increasing toward the substrate 101 in the second horizontal direction (e.g., the y direction). This is because, when the first and second contact plugs 170a and 170b are formed by a wet etching process, openings corresponding to the second contact plugs 170a and 170b may be formed along a third side surface 181S3 of the first isolation insulating pattern 181 having the third slope. However, when the first and second contact plugs 170a and 170b are formed by a dry etching process, the width may decrease toward the substrate 101.

**In** an example embodiment, a side surface of the second isolation insulating pattern 182 may have a side surface 182S having a fourth slope as illustrated in FIGS. 2A and 2C. A side surface of the second isolation insulating pattern 182 may have substantially the same slope in the first horizontal direction and the second horizontal direction. The second isolation insulating pattern 182 may have the side surface 182S having the constant fourth slope. The fourth slope may be, for example, about 80 degrees to about 100 degrees, such as, for example, about 90 degrees. However, the shape of the side surface of the second isolation insulating pattern 182 is not limited thereto and may be varied.

In an example embodiment, the third and fourth contact plugs 170a and 170b may have a width decreasing toward the substrate 101 or may have a constant width, in the second horizontal direction (e.g., the y direction).

The first and second isolation insulating patterns 181 and 182 may have different side surface profiles as the first and second isolation insulating patterns 181 and 182 may be formed by different etching processes. For example, the first isolation insulating pattern 181 may be a structure formed by selectively etching the interlayer insulating layer 190 with respect to the adjacent gate structures 160 under a specific etching condition, and the second isolation insulating pattern 182 may be a structure formed by etching without an etching selectivity.

The first isolation insulating pattern 181 may extend by penetrating through a portion of the interlayer insulating layer 190 disposed between the first and second gate structures 160a and 160b. The first isolation insulating pattern 181 may be disposed on the device isolation layers 107 between the first and second active regions 105a and 105b. The second isolation insulating pattern 182 may extend by penetrating through a portion of the interlayer insulating layer 190 disposed between the third and fourth gate structures 160c and 160d. The second isolation insulating pattern 182 may be disposed on the device isolation layers 107 between the third and fourth active regions 105c and 105d.

Referring to FIGS. 2A and 2C, a first length L1 of the first isolation insulating pattern 181 in the z direction is smaller than a second length L2 of the second isolation insulating pattern 182 in the z direction. Upper surfaces of the first and second isolation insulating patterns 181 and 182 may be disposed on substantially the same level. That is, the first isolation insulating pattern 181 may extend by penetrating through the interlayer insulating layer 190 by a depth relatively smaller than that of the second isolation insulating pattern 182. Accordingly, the lower surface of the first isolation insulating pattern 181 may be disposed on a level higher than a level of the lower surface of the second isolation insulating pattern 182. In an example embodiment, the lower surface of the first isolation insulating pattern 181 may be disposed on a level higher than a level of the lower surface of each of the source/drain regions 150, and the lower surface of the second isolation insulating pattern 182 may be disposed on a level lower than a level of the lower surface of each of the source/drain regions 150. The lower surface of the first isolation insulating pattern 181 may be disposed in the interlayer insulating layer 190, and the lower surface of the second isolation insulating pattern 182 may be disposed in the device isolation layer 107.

The average width and/or average planar area of the first isolation insulating pattern 181 may be smaller than the average width and/or average planar area of the second isolation insulating pattern 182. In example embodiments, "average width" may refer to an average value of widths at each level of a corresponding component, and "average planar area" may refer to an average value of planar areas at each level of a corresponding component.

The first isolation insulating pattern 181 may be spaced apart from the source/drain regions 150 and/or the device isolation layers 107. The second isolation insulating pattern 182 may be disposed to be in contact with the source/drain regions 150 and/or the device isolation layers 107. This is because the second isolation insulating pattern 182 may be configured as an insulating pattern extending by a depth greater than that of the first isolation insulating pattern 181 and penetrating through at least a portion of the source/drain regions 150 and/or the device isolation layers 107.

In an example embodiment, the first isolation insulating pattern 181 may be spaced apart from the spacer structure 164, and the second isolation insulating pattern 182 may be in contact with the spacer structure 164. This is because the second isolation insulating pattern 182 may be configured as an insulating pattern having a width greater than a width of the first isolation insulating pattern 181 and formed in an opening penetrating through at least a portion of the spacer structure 164 together with the interlayer insulating layer 190.

In an example embodiment, the first and second isolation insulating patterns 181 and 182 may include the same insulating material. However, in example embodiments, the first and second isolation insulating patterns 181 and 182 may include different materials. This may be because the first and second isolation insulating patterns 181 and 182 may be formed through different processes.

As the first isolation insulating patterns 181 are formed by an etching process having an etch selectivity, the contact plugs 170 may be isolated without affecting electrical properties of the transistors including the gate structures 160 and the source/drain regions 150. As the second isolation insulating patterns 182 are formed by an etching process having no etch selectivity, the second isolation insulating patterns 182 may extend by a relatively deep depth, thereby preventing leakage current caused by contact between the contact plugs 170 adjacent to each other. In the semiconductor device 100 according to the example embodiments, since the first and second isolation insulating patterns 181 and 182, two types of isolation insulating patterns, are selectively disposed for each region, the semiconductor device 100 having improved electrical properties and productivity may be provided.

The interlayer insulating layer 190 may cover the source/drain regions 150 and the gate structures 160, and may cover the device isolation layers 107. The interlayer insulating layer 190 may include, for example, at least one of oxide, nitride, and oxynitride, and may include a low-k material.

In an example embodiment, the semiconductor device 100 may further include an insulating liner 191 covering a lower surface of the interlayer insulating layer 190. The insulating liner 191 may include a material different from that of the interlayer insulating layer, such as, for example, silicon nitride or a silicon nitride-based insulating material. The insulating liner 191 may be disposed between the device isolation layers 107 and the interlayer insulating layer 190 and may extend to surfaces of the source/drain regions 150 not in contact with the contact plugs 170. Also, the insulating liner 191 may extend to side surfaces of the gate structures 160.

In an example embodiment, a lower surface of the capping layer 166 may cover the gate electrode 165, the spacer structure 164, and the insulating liner 191 extending to side surfaces of the spacer structure 164.

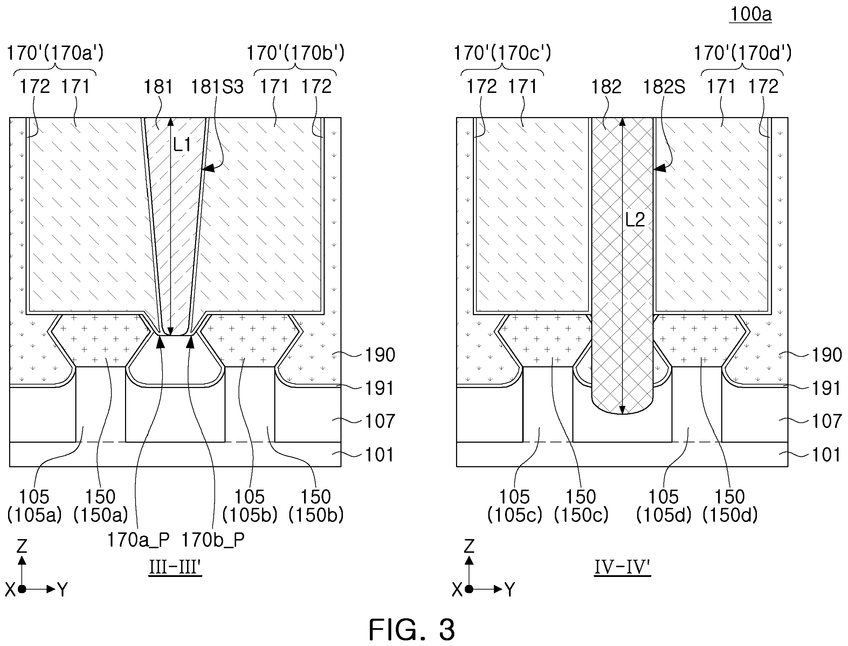

FIG. 3 is a cross-sectional diagram illustrating a semiconductor device 100a according to an example embodiment, taken along lines III-III' and IV-IV' in FIG. 1.

Referring to FIG. 3, the semiconductor device 100a may have a structure of contact plugs 170' different from the examples in FIGS. 1 to 2C.

The contact plugs 170' may have a relatively large width in the second horizontal direction (e.g., the y direction). In an example embodiment, the first and second contact plugs 170a' and 170b' may be in contact with the third side surface 181S3 of the first isolation insulating pattern 181 in the second horizontal direction. The first isolation insulating pattern 181 may be spaced apart from the first and second source/drain regions 150a and 150b. Each of the first and second contact plugs 170a' and 170b' may include extension portions 170a_P and 170b_P extending to a space between the first and second source/drain regions 150a and 150b and first isolation insulating pattern 181. The extension portions 170a_P and 170b_P may cover a lower end of the third side surface 181S3 or a portion of a lower surface of the first isolation insulating pattern 181. However, the extension portions 170a_P and 170b_P of the first and second contact plugs 170a' and 170b' may be spaced apart from each other.

In an example embodiment, the third and fourth contact plugs 170c' and 170d' may be in contact with the second isolation insulating pattern 182 in the second horizontal direction.

The second isolation insulating pattern 182 may be in contact with the third and fourth source/drain regions 150c and 150d. Differently from the first and second contact plugs 170a' and 170b', the third and fourth contact plugs 170c' and 170d' may not include extension portions. This is because there may be no space between the source/drain regions 150 and the second isolation insulating patterns 182 as the second isolation insulating patterns 182 in contact with the source/drain regions 150 have a relatively great width and great depth as compared to the first isolation insulating pattern 181.

The contact plugs 170' according to the example embodiments may have a structure formed through, for example, a wet etching process. When an opening having a relatively larger width (defined in the second horizontal direction) as compared to the example in FIG. 2C is formed through the wet etching process, the openings adjacent to the first isolation insulating pattern 181 may include a portion extending to a space between the first isolation insulating pattern 181 and the source/drain regions 150, but the openings adjacent to the second isolation insulating pattern 182 may not include a portion extending into the space between the second isolation insulating pattern 182 and the source/drain regions 150.

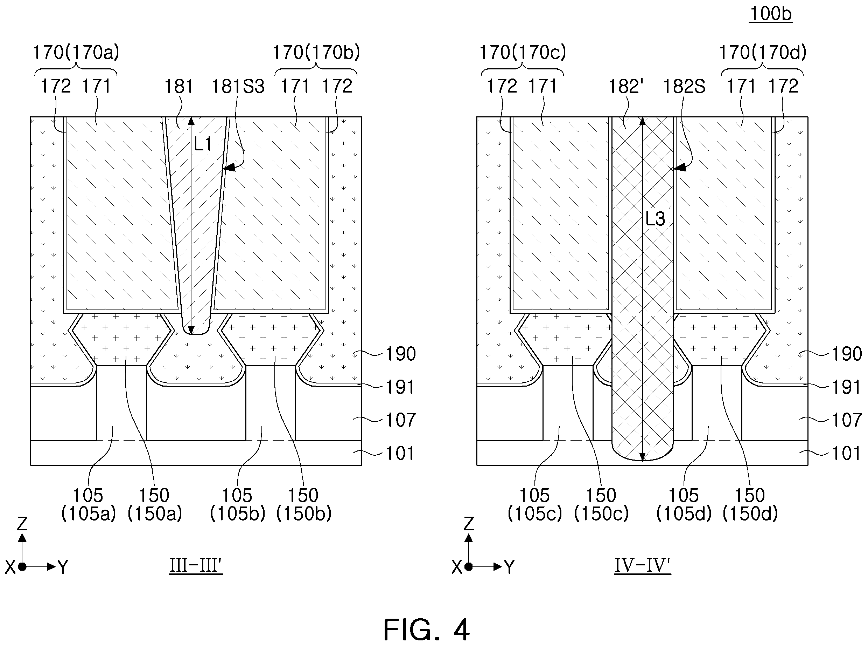

FIG. 4 is a cross-sectional diagram illustrating a semiconductor device 100b according to an example embodiment, taken along lines III-III' and IV-IV' in FIG. 1.

Referring to FIG. 4, the semiconductor device 100b may have a second isolation insulating pattern 182' structure different from the example described with reference to FIGS. 1 to 2C.

The third length L3 of the second isolation insulating pattern 182' in the z direction may be greater than the first length L1 of the first isolation insulating pattern 181 in the z direction. The third length L3 may be greater than the second length L2 of the second isolation insulating pattern 182 in FIG. 2C. The second isolation insulating pattern 182' may penetrate through the device isolation layers 107 together with the interlayer insulating layer 190. In an example embodiment, the second isolation insulating pattern 182' may extend into the substrate 101 by penetrating through the device isolation layers 107 and may be in contact with the substrate 101. However, in example embodiments, the second isolation insulating pattern 182' may be in contact with the upper surface of the substrate 101 without forming a recess portion of the substrate 101.

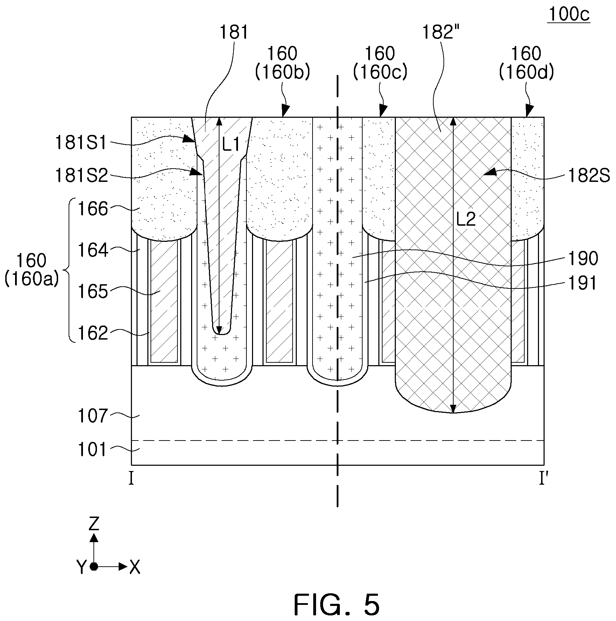

FIG. 5 is a cross-sectional diagram illustrating a semiconductor device 100c according to an example embodiment, taken along line I-I' in FIG. 1.

Referring to FIG. 5, the semiconductor device 100c may have a second isolation insulating pattern 182" structure different from the example described with reference to FIGS. 1 to 2C.

The second isolation insulating pattern 182" may be in contact with the gate electrode 165. A portion of a side surface of the second isolation insulating pattern 182" may be in contact with the gate electrode 165 of the gate structures 160 and with the capping layer 166. This may be because the second isolation insulating pattern 182" is formed in the opening having a relatively large width as compared to FIG. 2C. The opening may remove the spacer structure 164 and may expose the gate electrode 165, and the second isolation insulating pattern 182" may be in contact with the exposed gate electrode 165.

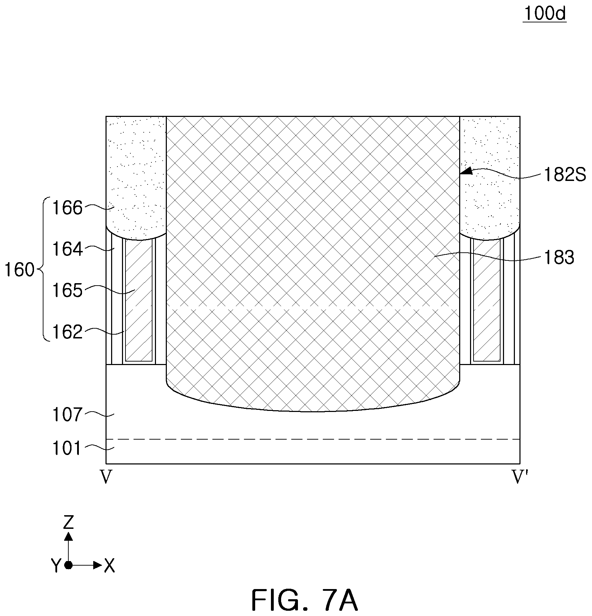

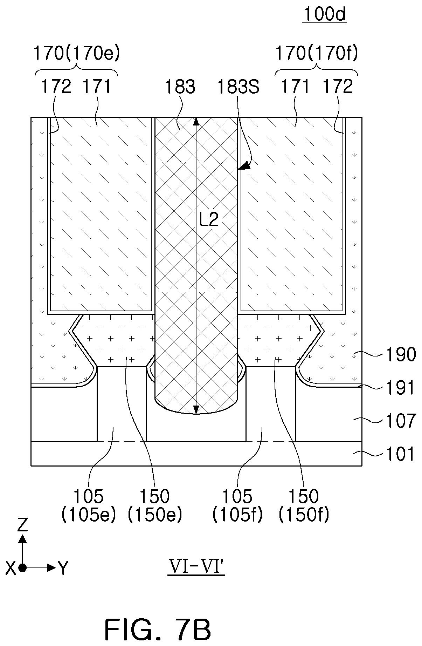

FIG. 6 is a cross-sectional diagram illustrating a semiconductor device 100d according to an example embodiment. FIG. 7A is a cross-sectional diagram taken along line V-V' in FIG. 6, and FIG. 7B is a cross-sectional diagram taken along line VI-VI'. Only the main components of the semiconductor device are illustrated in FIGS. 6 to 7B for ease of description.

Referring to FIGS. 6 to 7B, the semiconductor device 100d may further include a third isolation insulating pattern 183 that isolates contact plugs 170 adjacent to each other. The semiconductor device 100d according to the example embodiments may further include a third isolation insulating pattern 183 disposed in one region of the semiconductor device 100 in FIGS. 1 to 2C.

The active regions 105 may include fifth and sixth active regions 105e and 105f extending in a first horizontal direction, spaced apart from each other in a second horizontal direction, and extending in parallel to each other. The source/drain regions 150 may include a fifth source/drain region 150e disposed on the fifth active region 105e and a sixth source/drain region 150f disposed on the sixth active region 105f. The contact plugs 170 may include a fifth contact plug 170e connected to a fifth source/drain region 150e and a sixth contact plug connected to a sixth source/drain region 150f between the gate structures 160 adjacent to each other.

The third isolation insulating pattern 183 may isolate the fifth and sixth contact plugs 170e and 170f. The third isolation insulating pattern 183 may be an insulating pattern in which an insulating material is filled in a line-shaped trench. The third isolation insulating pattern 183 may extend in the first horizontal direction parallel to the active regions 105.

The third isolation insulating pattern 183 may penetrate through a plurality of gate structures 160 adjacent to each other (e.g., a plurality of adjacent gate structures). Accordingly, the gate structures 160 may include first isolation gate structures 160S1 and second isolation gate structures 160S2 spaced apart from the first isolation gate structures 160S1 in the second horizontal direction by the third isolation insulating pattern 183.

The third isolation insulating pattern 183 may include the same material as that of the second isolation insulating pattern 182 (see FIG. 2C). The third isolation insulating pattern 183 may have substantially the same length as the second length L2 of the second isolation insulating pattern 182. A lower surface of the third isolation insulating pattern 183 may be disposed on substantially the same level as a level of a lower surface of the second isolation insulating pattern 182. A lower surface of the third isolation insulating pattern 183 may be disposed on a level lower than a level of the source/drain regions 150. The third isolation insulating pattern 183 may be in contact with the source/drain regions 150 and/or the device isolation layers 107. This may be because the third isolation insulating pattern 183 is formed through the same etching process as the second isolation insulating pattern 182.

In the semiconductor device 100d according to an example embodiment, the isolation insulating patterns 180 may further include the third isolation insulating pattern 183 together with the first and second isolation insulating patterns 181 and 182 in FIGS. 1 to 2C, but an example embodiment thereof is not limited thereto, and only the first and third isolation insulating patterns 181 and 183 may be included in example embodiments.

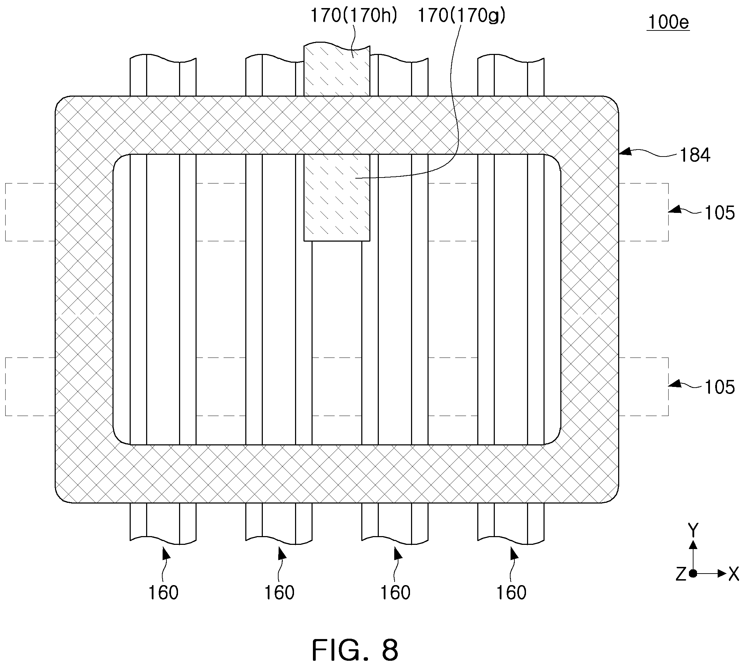

FIG. 8 is a cross-sectional diagram illustrating a semiconductor device 100e according to an example embodiment.

Referring to FIG. 8, the semiconductor device 100e may further include a fourth isolation insulating pattern 184 isolating contact plugs 170 adjacent to each other. The semiconductor device 100e according to the example embodiments may further include a fourth isolation insulating pattern 184 disposed in one region of the semiconductor device 100 in FIGS. 1 to 2C.

The fourth isolation insulating pattern 184 may isolate the seventh and eighth contact plugs 170g and 170h adjacent to each other.

The fourth isolation insulating pattern 184 may be configured as an insulating pattern in which a dam-shaped opening surrounding the closed space is filled with an insulating material to allow a specific closed space to be distinct.

**In** an example embodiment, the fourth isolation insulating pattern 184 may surround a plurality of active regions 105 adjacent to each other among the active regions 105 (e.g., a plurality of adjacent active regions) and a plurality of gate structures 160 intersecting the plurality of active regions 105 among the gate structures 160. **In** an example embodiment, the number of the plurality of active regions 105 may be two and the number of the plurality of gate structures 160 may be four, but the number of the plurality of active regions 105 and the number of the plurality of gate structures 160 are not limited thereto.

The fourth isolation insulating pattern 184 may include the same material as that of the second isolation insulating pattern 182 (see FIG. 2C). The fourth isolation insulating pattern 184 may have substantially the same length as the second length L2 of the second isolation insulating pattern 182. The lower surface of the fourth isolation insulating pattern 184 may be disposed on substantially the same level as that of the lower surface of the second isolation insulating pattern 182. A lower surface of the fourth isolation insulating pattern 184 may be disposed on a level lower than a level of that of the source/drain regions 150. The fourth isolation insulating pattern 184 may be in contact with the source/drain regions 150 and/or the device isolation layers 107.

This may be because the fourth isolation insulating pattern 184 is formed through the same etching process as the second isolation insulating pattern 182.

**In** the semiconductor device 100e according to the example embodiment, the isolation insulating patterns 180 may further include the fourth isolation insulating pattern 184 together with the first and second isolation insulating patterns 181 and 182 in FIGS. 1 to 2C, but an example embodiment thereof is not limited thereto, and in example embodiments, the isolation insulating patterns 180 may only include the first and fourth isolation insulating patterns 181 and 184 or may further include the third isolation insulating pattern 183 in FIG. 7.

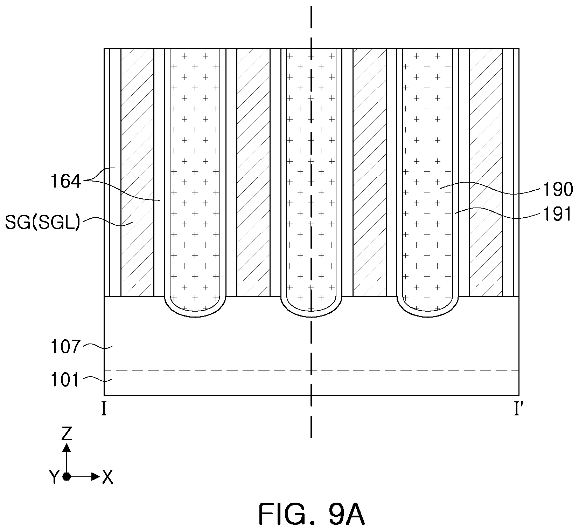

FIGS. 9A to 13B are diagrams illustrating processes of a method of manufacturing a semiconductor device in order according to an example embodiment, illustrating an example of a method of manufacturing a semiconductor device in FIGS. 1 to 2C.

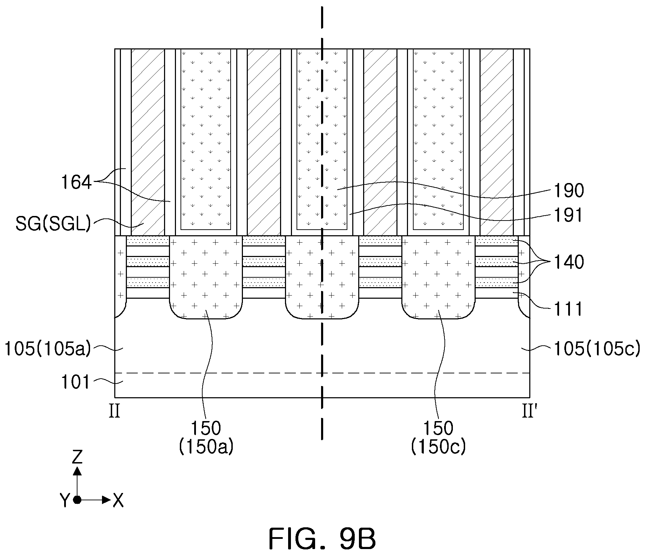

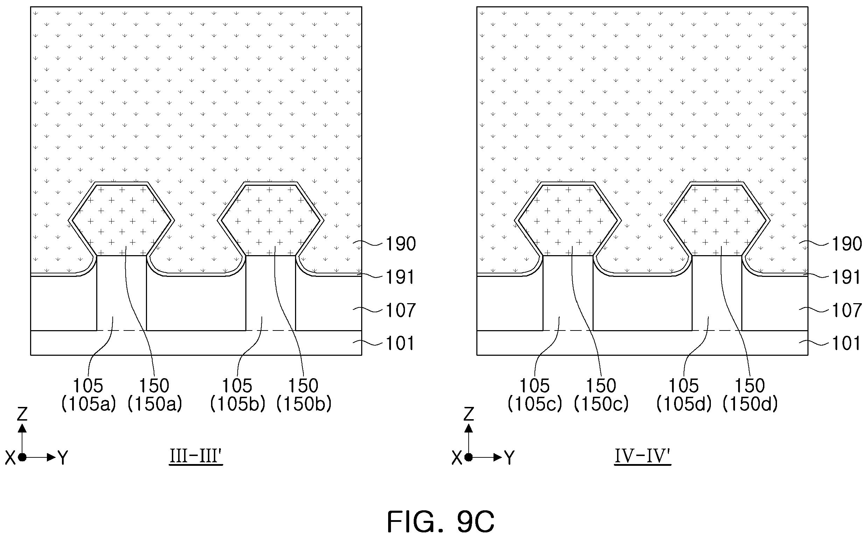

FIGS. 9A, 10A, 11A, and 12A are cross-sectional diagrams corresponding to a region taken along line I-I' in FIG. 1. FIGS. 9B, 10B, and 13A are cross-sectional diagrams corresponding to a region taken along line II-II' in FIG. 1. FIGS. 9C, 11B, 12B, and 13B are cross-sectional diagrams corresponding to regions taken along lines III-III' and IV-IV' in FIG. 1.

Referring to FIGS. 9A, 9B, and 9C, active regions 105 may be formed on a substrate 101, sacrificial gate structures SG intersecting the active regions 105 may be formed, source/drain regions 150 may be formed, an interlayer insulating layer 190 may be formed, the sacrificial gate structures SG may be removed, and gate structures 160 may be formed.

Sacrificial layers 111 and channel layers 140 alternately stacked on the substrate 101 may be formed, and a trench defining the active regions 105 may be formed by at least a portion of the sacrificial layers 111, the channel layers 140, and the substrate 101. The sacrificial layers 111 and the channel layers 140 may be formed by an epitaxial growth process. The sacrificial layers 111 may be formed of a material having etch selectivity with respect to the channel layers 140. The sacrificial layers 111 and the channel layers 140 may include, for example, a semiconductor material including at least one of silicon (Si), silicon germanium (SiGe), and germanium (Ge), and may include different materials. The sacrificial layers 111 may include, for example, silicon germanium (SiGe), and the channel layers 140 may include silicon (Si).

The active regions 105 may be defined by the trench. The active regions 105 may be formed to protrude to the upper surface of the substrate 101 by removing a portion of the substrate 101. The active regions 105 may have a shape protruding in the z-direction, which may be a direction perpendicular to the substrate 101, and may be formed of the same material as that of the substrate 101. The active regions 105 may be formed in a line shape extending in a first horizontal direction (e.g., x-direction), and may be spaced apart from each other in a second horizontal direction (e.g., y direction). In an example embodiment, the active regions 105 may include first and second active regions 105a and 105b, and third and fourth active regions 105c and 105d, spaced apart from each other in the y direction.

The device isolation layers 107 may be formed in the region from which the substrate 101 is partially removed by filling the insulating material therein and partially removing the insulating material to allow the active regions 105 to protrude. The device isolation layers 107 may cover a portion of side surfaces of the active regions 105. A level of an upper surface of the device isolation layers 107 may be lower than a level of an upper surface of the active regions 105. The device isolation layers 107 may include silicon oxide.

Thereafter, the sacrificial gate structures SG intersecting the active regions 105 and parallel to each other may be formed. Each of the sacrificial gate structures SG may have a line shape extending in one direction, that is, for example, the y direction. The sacrificial gate structures SG may be sacrificial structures formed in a region in which the gate dielectric layer 162 and the gate electrode 165 are disposed on the channel layers 140 through a subsequent process. The sacrificial gate structures SG may include a sacrificial gate layer SGL and a sacrificial gate capping layer stacked in order. The sacrificial gate layer SGL may be formed of, for example, polysilicon, and the sacrificial gate capping layer may be formed of a silicon nitride layer. However, the structure and material of the sacrificial gate structures SG may be varied.

Spacer structures 164 may be formed on both sidewalls of the sacrificial gate structures SG. The spacer structure 164 may be formed by forming a film having a uniform thickness along the upper and side surfaces of the sacrificial gate structures SG and the upper surface of the active regions 105 and performing an anisotropic etching process. The spacer structure 164 may include an insulating material, such as, for example, at least one of SiO, SiN, SiCN, SiOC, SiON, and SiOCN.

Thereafter, the active regions 105 may be exposed by etching portions of the sacrificial layers 111 and the channel layers 140 using the sacrificial gate structures SG and the spacer structure 164 as an etch mask, and the source/drain regions 150 may be formed on the exposed active regions 105.

A recess portion may be formed by removing the exposed sacrificial layers 111 and the channel layers 140 between the sacrificial gate structures SG, and the active regions 105 may be exposed. A portion of the substrate 101 may be recessed by forming the recess portion deeply, but an example embodiment thereof is not limited thereto, and the recess portion may be recessed such that a lower surface of the recess portion may be in contact with the substrate 101.

The source/drain regions 150 may be formed by performing an epitaxial growth process in the recess portion. The source/drain regions 150 may include impurities by, for example, in-situ doping.

Thereafter, the insulating liner 191 and the interlayer insulating layer 190 may be formed in order, and a planarization process may be performed until the sacrificial gate layer SGL is exposed.

The insulating liner 191 may cover the sacrificial gate structures, the spacer structure 164, the source/drain regions 150, and the device isolation layers 107. The interlayer insulating layer 190 may cover a side surface and an upper surface of the insulating liner 191. The interlayer insulating layer 190 may be formed of silicon oxide or a low dielectric material, and the insulating liner 191 may be formed of a material different from that of the interlayer insulating layer 190, such as, for example, silicon nitride or a silicon nitride-based insulating material. A portion of the spacer structure 164 and the sacrificial gate capping layer may be removed through the planarization process.

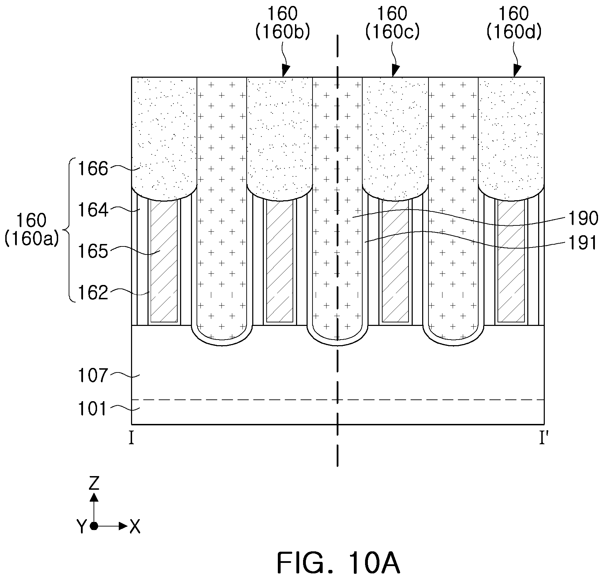

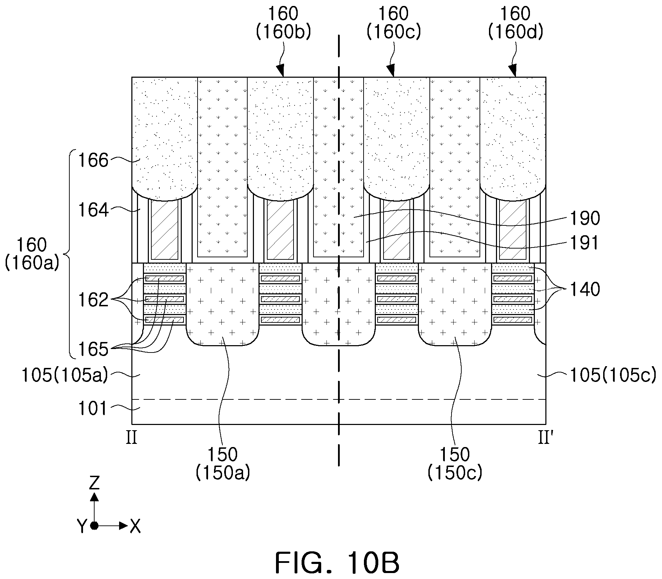

Referring to FIGS. 10A and 10B, the sacrificial layers 111 and the sacrificial gate structures SG may be removed and the gate structures 160 may be formed.

The sacrificial layers 111 and the sacrificial gate structures may be selectively removed with respect to the spacer structure 164, the interlayer insulating layer 190, and the channel layers 140. First, upper gap regions may be formed by removing the sacrificial gate layer SGL exposed through the planarization process, and lower gap regions may be formed by removing the sacrificial layers 111 exposed through the upper gap regions. For example, when the sacrificial layers 111 include silicon germanium (SiGe) and the channel layers 140 include silicon (Si), the sacrificial layers 111 may be selectively removed by performing a wet etching process using peracetic acid as an etchant.

A gate dielectric layer 162 and a gate electrode 165 may be formed in order in the upper gap region and the lower gap region. The gate dielectric layer 162 may be formed to conformally cover internal surfaces of the upper gap regions and the lower gap regions. The gate electrode 165 may be formed by entirely filling the upper gap regions and the lower gap regions.

The capping layer 166 may be formed by lowering the level of the upper surface by partially etching from the upper portion of the gate electrode 165 and the upper portion of the spacer structure 164 by a predetermined depth, filling an insulating material in the space formed as the upper surface is lowered, and performing a planarization process. The planarization process may be performed such that the upper surface of the interlayer insulating layer 190 may be exposed, but in example embodiments, a portion of the upper surface of the interlayer insulating layer 190 may be recessed. The capping layer 166 may be formed of silicon nitride or a silicon nitride-based insulating material. Accordingly, each of the gate structures 160 including the gate dielectric layer 162, the spacer structure 164, the gate electrode 165, and the capping layer 166 may be formed. In an example embodiment, the gate structures 160 may include first and second gate structures 160a and 160b intersecting the first and second active regions 105a and 105b, wherein the first and second gate structures 160a and 160b are spaced apart from each other and extend in parallel to each other. Also, the gate structures 160 may include third and fourth gate structures 160c and 160d intersecting the third and fourth active regions 105c and 105d, wherein the third and fourth gate structures 160c and 160d are spaced apart from each other and extend in parallel to each other.

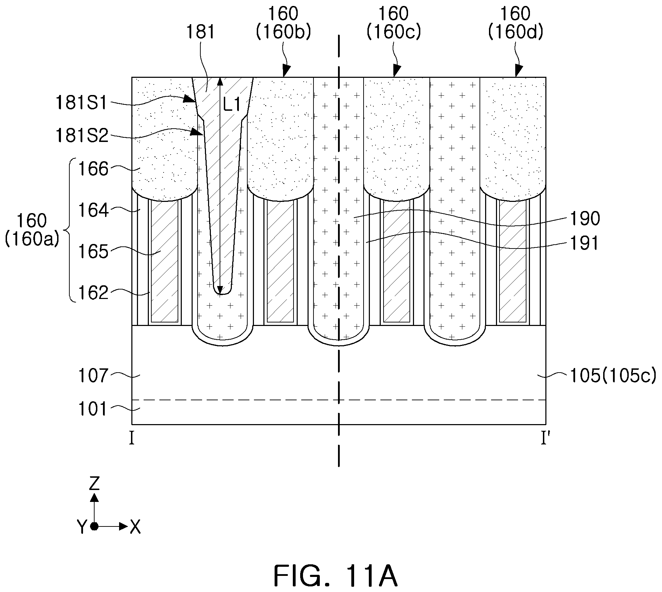

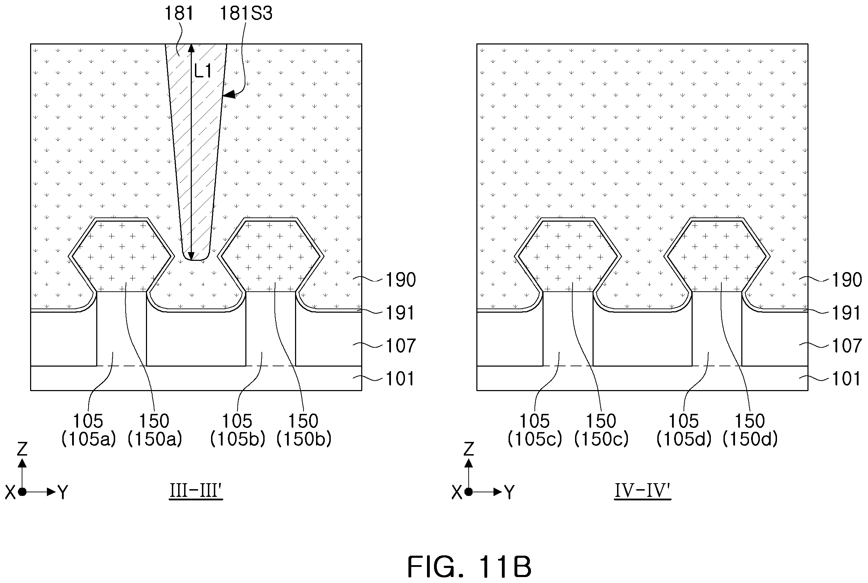

Referring to FIGS. 11A and 11B, a first isolation insulating pattern 181 may be formed.

The first isolation insulating pattern 181 may be formed by forming an opening penetrating the interlayer insulating layer 190 on the device isolation layers 107 between the first and second gate structures 160a and 160b and filling the opening with an insulating material. The insulating material may include oxide, nitride, carbide, or a combination thereof, and may include, for example, silicon nitride. The opening may be formed by performing a patterning process, such as an exposure process, on a region corresponding to the opening, and performing an etching process. The etching process may be, for example, a dry etching process. **In** an example embodiment, the etching process may be a process of selectively removing the interlayer insulating layer 190 with respect to the gate structures 160 under a specific etching condition. **In** the etching process, a portion of the capping layer 166 may be removed even in a process having an etch selectivity. Alternatively, in example embodiments, the capping layer 166 may not be removed.

As the planarization process is performed after filling the opening with an insulating material, the upper surface of the first isolation insulating pattern 181 may be substantially coplanar with the upper surface of the capping layer 166. The first isolation insulating pattern 181 may have a first length L1 in the z direction. A lower surface of the first isolation insulating pattern 181 may be disposed on a level higher than a level of lower surfaces of the source/drain regions 150. This may be because the first isolation insulating pattern 181 may be a region corresponding to the opening having a relatively small width and extending by a thin depth by the etching process having the etch selectivity. As the first isolation insulating pattern 181 is formed by an etching process having the etch selectivity, the first isolation insulating pattern 181 may not affect electrical properties of the adjacent gate structures 160.

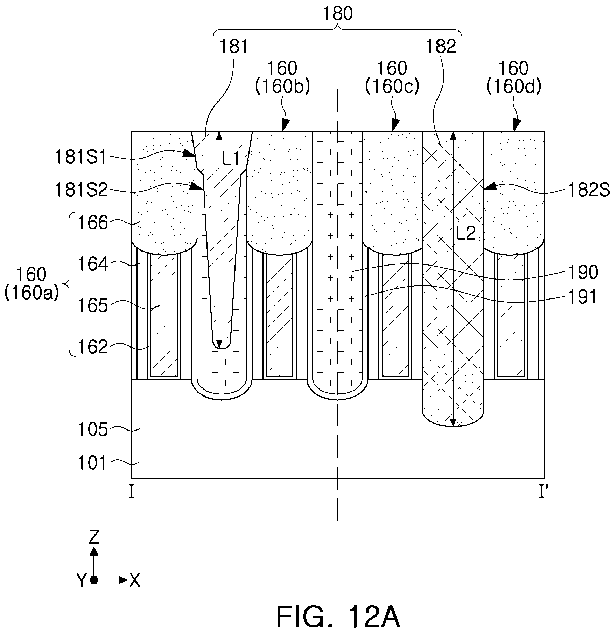

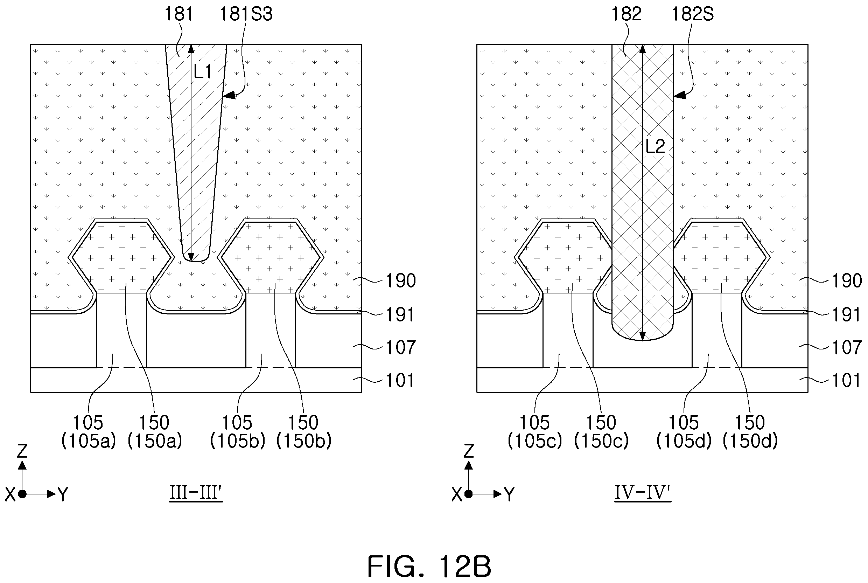

Referring to FIGS. 12A and 12B, a second isolation insulating pattern 182 may be formed.

The second isolation insulating pattern 182 may be formed by forming an opening penetrating the interlayer insulating layer 190 on the device isolation layers 107 between the third and fourth gate structures 160c and 160d, and filling the opening with an insulating material. The insulating material may include oxide, nitride, carbide, or a combination thereof, such as, for example, silicon nitride. The second isolation insulating pattern 182 may include an insulating material different from that of the first isolation insulating pattern 181, but an example embodiment thereof is not limited thereto and the first isolation insulating pattern 181 and the second isolation insulating pattern 182 may include the same insulating material. The opening may be formed by performing a patterning process, such as an exposure process, on a region corresponding to the opening, and performing an etching process. The etching process may be, for example, a dry etching process. In an example embodiment, the etching process may be performed to form the opening by anisotropic etching without an etching selectivity. Accordingly, the etching process may remove at least a portion of the insulating liner 191 and the spacer structure 164 together with the interlayer insulating layer 190. Also, in an example embodiment, the etching process may remove a portion of the source/drain regions 150 (see, e.g., FIG. 12B).

As the planarization process is performed after filling the opening with an insulating material, the upper surface of the second isolation insulating pattern 182 may be substantially coplanar with the upper surface of the capping layer 166. The second isolation insulating pattern 182 may have a second length L2 in the z direction. A lower surface of the second isolation insulating pattern 182 may be disposed on a level lower than a level of the lower surface of the source/drain regions 150. This may be because the second isolation insulating pattern 182 may be a region corresponding to an opening having a relatively large width and extending by a deep depth by an etching process without an etching selectivity. As the second isolation insulating pattern 182 is formed by an etching process without an etching selectivity, the second isolation insulating pattern 182 may extend by a deep depth such that leakage current caused by contact between adjacent contact plugs 170 formed through a subsequent process may be prevented or addressed.

In an example embodiment, as described with reference to FIGS. 11A to 12B, the first isolation insulating pattern 181 may be formed, and the second isolation insulating pattern 182 may be formed thereafter, or alternatively, the first and second isolation insulating patterns 181 and 182 may be formed by forming an opening corresponding to the first isolation insulating pattern 181, forming an opening corresponding to the second isolation insulating pattern 182, and filling an insulating material simultaneously. In this case, the first and second isolation insulating patterns 181 and 182 may include the same insulating material.

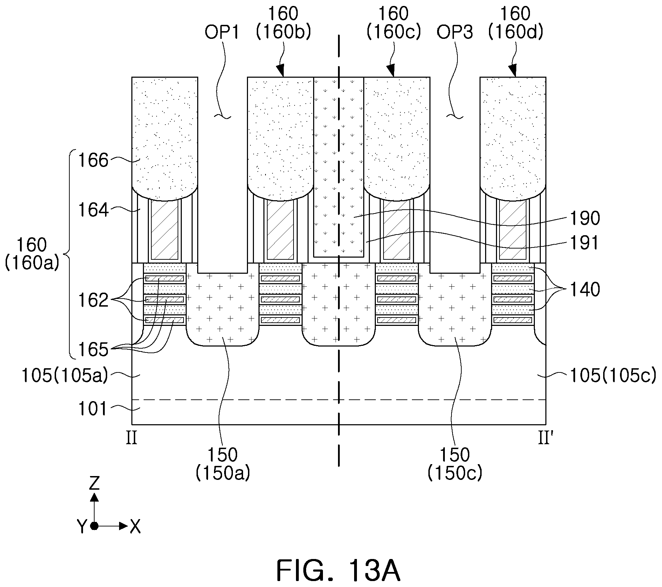

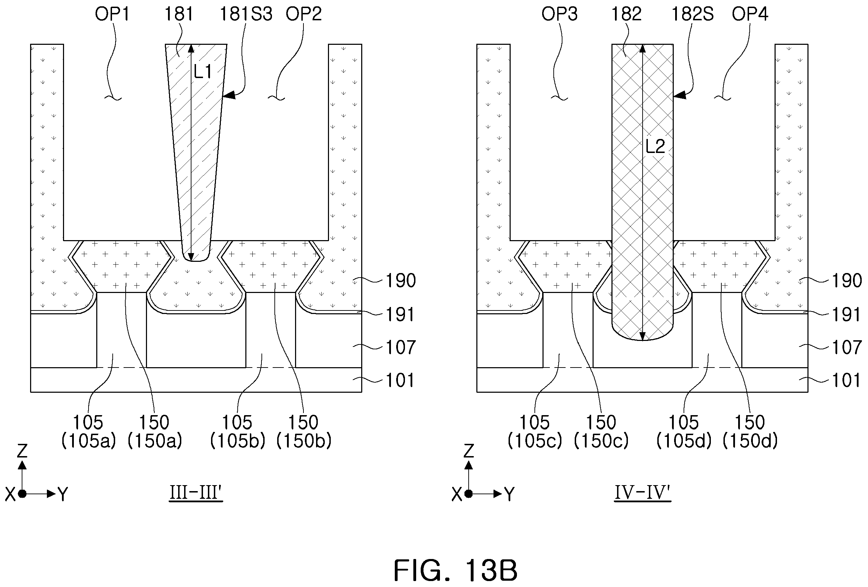

Referring to FIGS. 13A and 13B, contact openings OP1, OP2, OP3, and OP4 may be formed.

The contact openings OP1, OP2, OP3, and OP4 penetrating the interlayer insulating layer 190 and exposing the source/drain regions 150 may be formed by performing an etching process. The etching process may include a dry etching process or a wet etching process. The contact openings OP1, OP2, OP3, and OP4 may further extend from the source/drain regions 150 by a predetermined depth, but an example embodiment thereof is not limited thereto.

In an example embodiment, the contact openings OP1, OP2, OP3, and OP4 may be formed by etching the interlayer insulating layer 190 in a direction perpendicular to the substrate 101 along side surfaces of the capping layer 166, the first isolation insulating pattern 181, and the second isolation insulating pattern 182. Since the capping layer 166, the first isolation insulating pattern 181, and the second isolation insulating pattern 182 may include a material having strong etch resistance with respect to the interlayer insulating layer 190, the openings OP1, OP2, OP3, and OP4 may be formed without the components being etched. The capping layer 166, the first isolation insulating pattern 181, and the second isolation insulating pattern 182 may form contact openings OP1, OP2. OP3. OP4 for forming a self-aligning contact (SAC). Alternatively, the contact openings OP1, OP2, OP3, and OP4 may be formed to correspond to the patterned region through a mask patterned through an exposure process and an etching process.

In an example embodiment, the contact openings OP1, OP2, OP3, and OP4 may include a first contact opening OP1 exposing the first source/drain region 150a, a second contact opening OP2 exposing the second source/drain region 150b, a third contact opening OP3 exposing the third source/drain region 150c, and a fourth contact opening OP4 exposing the fourth source/drain region 150d.

The first and second contact openings OP1 and OP2 may be spaced apart from each other by the first isolation insulating pattern 181. The first and second contact openings OP1 and OP2 may expose a portion of a side surface of the first isolation insulating pattern 181.

The third and fourth contact openings OP3 and OP4 may be spaced apart from each other by the second isolation insulating pattern 182. The third and fourth contact openings OP3 and OP4 may expose a portion of a side surface of the second isolation insulating pattern 182.

In this process, when the first and second contact openings OP1 and OP2 are formed by a wet etching process and the openings are formed by a relatively deep depth, the first and second contact plugs 170a' and 170b' in FIG. 3 including the extension portions 170a_P and 170b_P may be formed.

Thereafter, referring to FIGS. 1 to 2C, contact plugs 170 may be formed by filling a conductive material in the contact openings OP1, OP2, OP3, and OP4 and performing a planarization process. In an example embodiment, each of the contact plugs 170 including the barrier layer 172 and the plug layer 171 may be formed by conformally forming a metal nitride layer, filling a metal material, and performing the planarization process.

According to the aforementioned example embodiments, by forming the isolation insulating patterns having different depths in different regions, a semiconductor device having improved electrical properties and productivity in which a leakage current defect between contact plugs formed through a subsequent process may be controlled may be provided.

While the example embodiments have been illustrated and described above, it will be configured as apparent to those skilled in the art that modifications and variations could be made without departing from the scope of the present disclosure as defined by the appended claims.

## Claims

1. A semiconductor device, comprising:
a substrate (101);
active regions (105) extending in a first horizontal direction on the substrate, wherein the active regions comprise a first active region (105a) and a second active region (105b) spaced apart from each other in a second horizontal direction perpendicular to the first horizontal direction, and a third active region (105c) and a fourth active region (105d) spaced apart from each other in the second horizontal direction;
gate structures (160) comprising a first gate structure (160a), a second gate structure (160b), a third gate structure (160c), and a fourth gate structure (160d), wherein the first gate structure (160a) and the second gate structure (160b) intersect the first active region (105a) and the second active region (105b) and are spaced apart from each other in the first horizontal direction, and wherein the third gate structure (160c) and the fourth gate structure (160d) intersect the third active region (105c) and the fourth active region (105d) and are spaced apart from each other in the first horizontal direction;
source/drain regions (150) comprising a first source/drain region (150a) on the first active region (105a) between the first gate structure (160a) and the second gate structure (160b), a second source/drain region (150b) on the second active region (105b) between the first gate structure (160a) and the second gate structure (160b), a third source/drain region (150c) on the third active region (105c) between the third gate structure (160c) and the fourth gate structure (160d), and a fourth source/drain region (150d) on the fourth active region (105d) between the third gate structure (160c) and the fourth gate structure (160d);
contact plugs (170) comprising a first contact plug (170a) connected to the first source/drain region (150a), a second contact plug (170b) connected to the second source/drain region (150b), a third contact plug (170c) connected to the third source/drain region (150c), and a fourth contact plug (170d) connected to the fourth source/drain region (150d);
a first isolation insulating pattern (181) between the first contact plug (170a) and the second contact plug (170b); and
a second isolation insulating pattern (182) between the third contact plug (170c) and the fourth contact plug (170d),
wherein a first length (L1) in a vertical direction of the first isolation insulating pattern (181) is smaller than a second length (L2) in the vertical direction of the second isolation insulating pattern (182), wherein the vertical direction is perpendicular to an upper surface of the substrate (101).

2. The semiconductor device of claim 1,
wherein the first isolation insulating pattern (181) separates the first contact plug (170a) and the second contact plug (170b) from each other and is in contact with each of the first contact plug (170a) and the second contact plug (170b), and
wherein the second isolation insulating pattern (182) separates the third contact plug (170c) and the fourth contact plug (170d) from each other and is in contact with each of the third contact plug (170c) and the fourth contact plug (170d).

3. The semiconductor device of claim 1 or 2, wherein an average width of the first isolation insulating pattern (181) is smaller than an average width of the second isolation insulating pattern (182) in the second horizontal direction.

4. The semiconductor device of claim 1, 2 or 3,
wherein a lower surface of the first isolation insulating pattern (181) is at a level higher than a level of a lower surface of each of the source/drain regions, and
wherein a lower surface of the second isolation insulating pattern (182) is at a level lower than the level of the lower surface of each of the source/drain regions.

5. The semiconductor device of any preceding claim,
wherein the first isolation insulating pattern (181) is spaced apart from the source/drain regions, and
wherein the second isolation insulating pattern (182) contacts the source/drain regions.

6. The semiconductor device of any preceding claim,
wherein each of the gate structures comprises a gate electrode extending in one direction, a spacer structure extending in the one direction on both sidewalls of the gate electrode, and a capping layer on the gate electrode and the spacer structure,
wherein the first isolation insulating pattern (181) is spaced apart from the spacer structure of each of the gate structures, and
wherein the second isolation insulating pattern (182) contacts the spacer structure of each of the gate structures.

7. The semiconductor device of claim 6, wherein the second isolation insulating pattern (182) contacts the gate electrode of each of the gate structures.

8. The semiconductor device of any preceding claim,
wherein the first isolation insulating pattern (181) comprises a first side surface having a first slope in the first horizontal direction, a second side surface having a second slope in the first horizontal direction different from the first slope, and a third side surface having a third slope in the second horizontal direction,
wherein the second isolation insulating pattern (182) comprises side surfaces in the first horizontal direction and the second horizontal direction, and
wherein slopes of the side surfaces of the second isolation insulating pattern (182) are substantially equal to each other.

9. The semiconductor device of any preceding claim,
wherein the first contact plug (170a) and the second contact plug (170b) have a width increasing toward the substrate in the second horizontal direction, and
wherein the third contact plug (170c) and the fourth contact plug (170d) have a width that is decreasing toward the substrate (101) or is constant in the second horizontal direction.

10. The semiconductor device of any preceding claim, wherein each of the first contact plug (170a) and the second contact plug (170b) comprises an extension portion extending to a region between the source/drain regions and the first isolation insulating pattern (181).

11. The semiconductor device of any preceding claim, further comprising:
a third isolation insulating pattern (183) extending in the first horizontal direction, wherein the third isolation insulating pattern (183) penetrates through a plurality of adjacent gate structures among the gate structures,
wherein the third isolation insulating pattern (183) and the second isolation insulating pattern (182) comprise a same material, and
wherein the third isolation insulating pattern (183) has a length in the vertical direction, substantially equal to the second length of the second isolation insulating pattern (182).

12. The semiconductor device of any preceding claim, further comprising:
a fourth isolation insulating pattern (184), wherein the fourth isolation insulating pattern (184) encloses, on a plane, a plurality of adjacent active regions among the active regions and a plurality of gate structures intersecting the plurality of adjacent active regions, wherein the plurality of gate structures intersecting the plurality of adjacent active regions are adjacent to each other among the gate structures,
wherein the fourth isolation insulating pattern (184) and the second isolation insulating pattern (182) comprise a same material, and
wherein the fourth isolation insulating pattern (184) has a length in the vertical direction, substantially equal to the second length of the second isolation insulating pattern (182).

13. The semiconductor device of any preceding claims, :
wherein the first isolation insulating pattern (181) is spaced apart from the first source/drain region (150a) and the second source/drain region (150b), and
wherein the second isolation insulating pattern (182) contacts the third source/drain region (150c) and the fourth source/drain region (150d).

14. The semiconductor device of claim 13, wherein a lower surface of the first isolation insulating pattern (181) is on a level higher than a level of a lower surface of the second isolation insulating pattern (182).

15. The semiconductor device of claim 13 or 14,
wherein the first isolation insulating pattern (181) comprises a plurality of side surfaces having different slopes, and
wherein the second isolation insulating pattern (182) comprises side surfaces having one slope.

## Patentansprüche

1. Halbleiterbauelement, umfassend:
ein Substrat (101);
aktive Bereiche (105), die sich in einer ersten horizontalen Richtung auf dem Substrat erstrecken, wobei die aktiven Bereiche einen ersten aktiven Bereich (105a) und einen zweiten aktiven Bereich (105b), die in einer zweiten horizontalen Richtung, senkrecht zur ersten horizontalen Richtung, voneinander beabstandet sind, und einen dritten aktiven Bereich (105c) und einen vierten aktiven Bereich (105d), die in der zweiten horizontalen Richtung voneinander beabstandet sind, umfassen;
Gate-Strukturen (160), umfassend eine erste Gate-Struktur (160a), eine zweite Gate-Struktur (160b), eine dritte Gate-Struktur (160c) und eine vierte Gate-Struktur (160d), wobei die erste Gate-Struktur (160a) und die zweite Gate-Struktur (160b) den ersten aktiven Bereich (105a) und den zweiten aktiven Bereich (105b) schneiden und in der ersten horizontalen Richtung voneinander beabstandet sind und wobei die dritte Gate-Struktur (160c) und die vierte Gate-Struktur (160d) den dritten aktiven Bereich (105c) und den vierten aktiven Bereich (105d) schneiden und in der ersten horizontalen Richtung voneinander beabstandet sind;
Source-/Drain-Bereiche (150), umfassend einen ersten Source-/Drain-Bereich (150a) auf dem ersten aktiven Bereich (105a) zwischen der ersten Gate-Struktur (160a) und der zweiten Gate-Struktur (160b), einen zweiten Source-/Drain-Bereich (150b) auf dem zweiten aktiven Bereich (105b) zwischen der ersten Gate-Struktur (160a) und der zweiten Gate-Struktur (160b), einen dritten Source-/Drain-Bereich (150c) auf dem dritten aktiven Bereich (105c) zwischen der dritten Gate-Struktur (160c) und der vierten Gate-Struktur (160d) und einen vierten Source-/Drain-Bereich (150d) auf der vierten aktiven Bereich (105d) zwischen der dritten Gate-Struktur (160c) und der vierten Gate-Struktur (160d);
Kontaktstecker (170), umfassend einen ersten Kontaktstecker (170a), der mit dem ersten Source-/Drain-Bereich (150a) verbunden ist, einen zweiten Kontaktstecker (170b), der mit dem zweiten Source-/Drain-Bereich (150b) verbunden ist, einen dritten Kontaktstecker (170c), der mit dem dritten Source-/Drain-Bereich (150c) verbunden ist, und einen vierten Kontaktstecker (170d), der mit dem vierten Source-/Drain-Bereich (150d) verbunden ist;
ein erstes Isolationsisolierungsmuster (181) zwischen dem ersten Kontaktstecker (170a) und dem zweiten Kontaktstecker (170b) und
ein zweites Isolationsisolierungsmuster (182) zwischen dem dritten Kontaktstecker (170c) und dem vierten Kontaktstecker (170d),
wobei eine erste Länge (L1) des ersten Isolationsisolierungsmusters (181) in einer vertikalen Richtung kleiner ist als eine zweite Länge (L2) des zweiten Isolationsisolierungsmusters (182) in der vertikalen Richtung, wobei die vertikale Richtung senkrecht zu einer Oberseite des Substrats (101) ist.

2. Halbleiterbauelement nach Anspruch 1,
wobei das erste Isolationsisolierungsmuster (181) den ersten Kontaktstecker (170a) und den zweiten Kontaktstecker (170b) voneinander trennt und mit sowohl dem ersten Kontaktstecker (170a) als auch dem zweiten Kontaktstecker (170b) in Kontakt steht und
wobei das zweite Isolationsisolierungsmuster (182) den dritten Kontaktstecker (170c) und den vierten Kontaktstecker (170d) voneinander trennt und mit sowohl dem dritten Kontaktstecker (170c) als auch dem vierten Kontaktstecker (170d) in Kontakt steht.

3. Halbleiterbauelement nach Anspruch 1 oder 2, wobei eine durchschnittliche Breite des ersten Isolationsisolierungsmusters (181) in der zweiten horizontalen Richtung kleiner ist als eine durchschnittliche Breite des zweiten Isolationsisolierungsmusters (182).

4. Halbleiterbauelement nach Anspruch 1, 2 oder 3,
wobei eine untere Oberfläche des ersten Isolationsisolierungsmusters (181) auf einem Niveau, höher als ein Niveau einer unteren Oberfläche jedes der Source-/Drain-Bereiche, liegt und
wobei eine untere Oberfläche des zweiten Isolationsisolierungsmusters (182) auf einem Niveau, niedriger als ein Niveau einer unteren Oberfläche jedes der Source-/Drain-Bereiche, liegt.

5. Halbleiterbauelement nach einem vorstehenden Anspruch,
wobei das erste Isolationsisolierungsmuster (181) von den Source-/Drain-Bereichen beabstandet ist und
wobei das zweite Isolationsisolierungsmuster (182) mit den Source-/Drain-Bereichen in Kontakt steht.

6. Halbleiterbauelement nach einem vorstehenden Anspruch,
wobei jede der Gate-Strukturen eine sich in einer Richtung erstreckende Gate-Elektrode, eine sich in der einen Richtung erstreckende Abstandsstruktur an beiden Seitenwänden der Gate-Elektrode und eine Deckschicht auf der Gate-Elektrode und der Abstandsstruktur umfasst,
wobei das erste Isolationsisolierungsmuster (181) von der Abstandsstruktur jeder Gate-Struktur beabstandet ist und
wobei das zweite Isolationsisolierungsmuster (182) mit der Abstandsstruktur jeder der Gate-Strukturen in Kontakt steht.

7. Halbleiterbauelement nach Anspruch 6, wobei das zweite Isolationsmuster (182) die Gate-Elektrode jeder der Gate-Strukturen kontaktiert.

8. Halbleiterbauelement nach einem vorstehenden Anspruch,
wobei das erste Isolationsisolierungsmuster (181) eine erste Seitenfläche, die eine erste Neigung in der ersten horizontalen Richtung aufweist, eine zweite Seitenfläche, die eine zweite Neigung in der ersten horizontalen Richtung, die sich von der ersten Neigung unterscheidet, aufweist, und eine dritte Seitenfläche, die eine dritte Neigung in der zweiten horizontalen Richtung aufweist, umfasst,
wobei das zweite Isolationsisolierungsmuster (182) Seitenflächen in der ersten horizontalen Richtung und der zweiten horizontalen Richtung aufweist und
wobei Neigungen der Seitenflächen des zweiten Isolationsisolierungsmusters (182) im Wesentlichen einander gleich sind.

9. Halbleiterbauelement nach einem vorstehenden Anspruch,
wobei der erste Kontaktstecker (170a) und der zweite Kontaktstecker (170b) eine Breite aufweisen, die sich in der zweiten horizontalen Richtung zum Substrat hin vergrößert, und
wobei der dritte Kontaktstecker (170c) und der vierte Kontaktstecker (170d) eine Breite aufweisen, die sich in der zweiten horizontalen Richtung zum Substrat (101) hin verringert oder konstant ist.

10. Halbleiterbauelement nach einem vorstehenden Anspruch, wobei jeder von dem ersten Kontaktstecker (170a) und dem zweiten Kontaktstecker (170b) einen Verlängerungsabschnitt umfasst, der sich bis zu einem Bereich zwischen den Source-/Drain-Bereichen und dem ersten Isolationsisolierungsmuster (181) erstreckt.

11. Halbleiterbauelement nach einem vorstehenden Anspruch, weiter umfassend:
ein drittes Isolationsmuster (183), das sich in der ersten horizontalen Richtung erstreckt, wobei das dritte Isolationsmuster (183) eine Vielzahl von benachbarten Gate-Strukturen unter den Gate-Strukturen durchdringt,
wobei das dritte Isolationsisolierungsmuster (183) und das zweite Isolationsisolierungsmuster (182) ein selbes Material umfassen und
wobei das dritte Isolationsisolierungsmuster (183) eine Länge in der vertikalen Richtung aufweist, die im Wesentlichen der zweiten Länge des zweiten Isolationsisolierungsmusters (182) gleich ist.

12. Halbleiterbauelement nach einem vorstehenden Anspruch, weiter umfassend:
ein viertes Isolationsisolierungsmuster (184), wobei das vierte Isolationsisolierungsmuster (184), auf einer Ebene, eine Vielzahl von benachbarten aktiven Bereichen und eine Vielzahl von Gate-Strukturen, welche die Vielzahl von benachbarten aktiven Bereichen schneiden, umschließt, wobei die Vielzahl von Gate-Strukturen, welche die Vielzahl von benachbarten aktiven Bereichen schneiden, unter den Gate-Strukturen zueinander benachbart sind,
wobei das vierte Isolationsisolierungsmuster (184) und das zweite Isolationsisolierungsmuster (182) ein selbes Material umfassen und
wobei das vierte Isolationsisolierungsmuster (184) eine Länge in vertikaler Richtung aufweist, die im Wesentlichen der zweiten Länge des zweiten Isolationsisolierungsmusters (182) gleich ist.

13. Halbleiterbauelement nach einem vorstehenden Anspruch, wobei:
wobei das erste Isolationsmuster (181) von dem ersten Source-/Drain-Bereich (150a) und dem zweiten Source-/Drain-Bereich (150b) beabstandet ist und
wobei das zweite Isolationsmuster (182) mit dem dritten Source-/Drain-Bereich (150c) und dem vierten Source-/Drain-Bereich (150d) in Kontakt steht.

14. Halbleiterbauelement nach Anspruch 13, wobei eine untere Oberfläche des ersten Isolationsisolierungsmusters (181) auf einem Niveau, höher als ein Niveau einer unteren Oberfläche des zweiten Isolationsisolierungsmusters (182), liegt.

15. Halbleiterbauelement nach Anspruch 13 oder 14,
wobei das erste Isolationsmuster (181) eine Vielzahl von Seitenflächen umfasst, die unterschiedliche Neigungen aufweisen, und
wobei das zweite Isolationsmuster (182) Seitenflächen umfasst, die eine Neigung aufweisen.

## Revendications

1. Dispositif semi-conducteur, comprenant :
un substrat (101) ;
des régions actives (105) s'étendant dans une première direction horizontale sur le substrat, dans lequel les régions actives comprennent une première région active (105a) et une deuxième région active (105b) espacées l'une de l'autre dans une seconde direction horizontale perpendiculaire à la première direction horizontale, et une troisième région active (105c) et une quatrième région active (105d) espacées l'une de l'autre dans la seconde direction horizontale ;
des structures de grille (160) comprenant une première structure de grille (160a), une deuxième structure de grille (160b), une troisième structure de grille (160c) et une quatrième structure de grille (160d), dans lequel la première structure de grille (160a) et la deuxième structure de grille (160b) croisent la première région active (105a) et la deuxième région active (105b) et sont espacées l'une de l'autre dans la première direction horizontale, et dans lequel la troisième structure de grille (160c) et la quatrième structure de grille (160d) croisent la troisième région active (105c) et la quatrième région active (105d) et sont espacées l'une de l'autre dans la première direction horizontale ;
des régions de source/drain (150) comprenant une première région de source/drain (150a) sur la première région active (105a) entre la première structure de grille (160a) et la deuxième structure de grille (160b), une deuxième région de source/drain (150b) sur la deuxième région active (105b) entre la première structure de grille (160a) et la deuxième structure de grille (160b), une troisième région de source/drain (150c) sur la troisième région active (105c) entre la troisième structure de grille (160c) et la quatrième structure de grille (160d), et une quatrième région de source/drain (150d) sur la quatrième région active (105d) entre la troisième structure de grille (160c) et la quatrième structure de grille (160d) ;
des fiches de contact (170) comprenant une première fiche de contact (170a) reliée à la première région de source/drain (150a), une deuxième fiche de contact (170b) reliée à la deuxième région de source/drain (150b), une troisième fiche de contact (170c) reliée à la troisième région de source/drain (150c) et une quatrième fiche de contact (170d) reliée à la quatrième région de source/drain (150d) ;
un premier motif isolant d'isolation (181) entre la première fiche de contact (170a) et la deuxième fiche de contact (170b) ; et
un deuxième motif isolant d'isolation (182) entre la troisième fiche de contact (170c) et la quatrième fiche de contact (170d),
dans lequel une première longueur (L1) dans la direction verticale du premier motif isolant d'isolation (181) est inférieure à une seconde longueur (L2) dans la direction verticale du deuxième motif isolant d'isolation (182), dans lequel la direction verticale est perpendiculaire à une surface supérieure du substrat (101).

2. Dispositif semi-conducteur selon la revendication 1,
dans lequel le premier motif isolant d'isolation (181) sépare la première fiche de contact (170a) et la deuxième fiche de contact (170b) l'une de l'autre et est en contact avec chacune de la première fiche de contact (170a) et de la deuxième fiche de contact (170b), et
dans lequel le deuxième motif isolant d'isolation (182) sépare la troisième fiche de contact (170c) et la quatrième fiche de contact (170d) l'une de l'autre et est en contact avec chacune de la troisième fiche de contact (170c) et de la quatrième fiche de contact (170d).

3. Dispositif semi-conducteur selon la revendication 1 ou 2, dans lequel une largeur moyenne du premier motif isolant d'isolation (181) est inférieure à une largeur moyenne du deuxième motif isolant d'isolation (182) dans la seconde direction horizontale.

4. Dispositif semi-conducteur selon la revendication 1, 2 ou 3,
dans lequel une surface inférieure du premier motif isolant d'isolation (181) est à un niveau supérieur à un niveau d'une surface inférieure de chacune des régions de source/drain, et
dans lequel une surface inférieure du deuxième motif isolant d'isolation (182) est à un niveau inférieur au niveau de la surface inférieure de chacune des régions de source/drain.

5. Dispositif semi-conducteur selon une quelconque revendication précédente,
dans lequel le premier motif isolant d'isolation (181) est espacé des régions de source/drain, et
dans lequel le deuxième motif isolant d'isolation (182) est en contact avec les régions de source/drain.

6. Dispositif semi-conducteur selon une quelconque revendication précédente,
dans lequel chacune des structures de grille comprend une électrode de grille s'étendant dans une direction, une structure d'espacement s'étendant dans la direction sur les deux parois latérales de l'électrode de grille, et une couche de recouvrement sur l'électrode de grille et la structure d'espacement,
dans lequel le premier motif isolant d'isolation (181) est espacé de la structure d'espacement de chacune des structures de grille, et
dans lequel le deuxième motif isolant d'isolation (182) entre en contact avec la structure d'espacement de chacune des structures de grille.

7. Dispositif semi-conducteur selon la revendication 6, dans lequel le deuxième motif isolant d'isolation (182) entre en contact avec l'électrode de grille de chacune des structures de grille.

8. Dispositif semi-conducteur selon une quelconque revendication précédente,
dans lequel le premier motif isolant d'isolation (181) comprend une première surface latérale présentant une première pente dans la première direction horizontale, une deuxième surface latérale présentant une deuxième pente dans la première direction horizontale différente de la première pente, et une troisième surface latérale présentant une troisième pente dans la seconde direction horizontale,
dans lequel le deuxième motif isolant d'isolation (182) comprend des surfaces latérales dans la première direction horizontale et la seconde direction horizontale, et
dans lequel les pentes des surfaces latérales du deuxième motif isolant d'isolation (182) sont sensiblement égales l'une à l'autre.

9. Dispositif semi-conducteur selon une quelconque revendication précédente,
dans lequel la première fiche de contact (170a) et la deuxième fiche de contact (170b) présentent une largeur augmentant vers le substrat dans la seconde direction horizontale, et
dans lequel la troisième fiche de contact (170c) et la quatrième fiche de contact (170d) présentent une largeur qui diminue vers le substrat (101) ou qui est constante dans la seconde direction horizontale.

10. Dispositif semi-conducteur selon une quelconque revendication précédente, dans lequel chacune de la première fiche de contact (170a) et de la deuxième fiche de contact (170b) comprend une partie d'extension s'étendant jusqu'à une région située entre les régions de source/drain et le premier motif isolant d'isolation (181).

11. Dispositif semi-conducteur selon une quelconque revendication précédente, comprenant en outre :
un troisième motif isolant d'isolation (183) s'étendant dans la première direction horizontale, dans lequel le troisième motif isolant d'isolation (183) pénètre à travers une pluralité de structures de grille adjacentes parmi les structures de grille,
dans lequel le troisième motif isolant d'isolation (183) et le deuxième motif isolant d'isolation (182) comprennent le même matériau, et
dans lequel le troisième motif isolant d'isolation (183) présente une longueur dans la direction verticale, sensiblement égale à la seconde longueur du deuxième motif isolant d'isolation (182).

12. Dispositif semi-conducteur selon une quelconque revendication précédente, comprenant en outre :
un quatrième motif isolant d'isolation (184), dans lequel le quatrième motif isolant d'isolation (184) renferme, sur un plan, une pluralité de régions actives adjacentes parmi les régions actives et une pluralité de structures de grille croisant la pluralité de régions actives adjacentes, dans lequel la pluralité de structures de grille croisant la pluralité de régions actives adjacentes sont adjacentes les unes aux autres parmi les structures de grille,
dans lequel le quatrième motif isolant d'isolation (184) et le deuxième motif isolant d'isolation (182) comprennent le même matériau, et
dans lequel le quatrième motif isolant d'isolation (184) présente une longueur dans la direction verticale, sensiblement égale à la seconde longueur du deuxième motif isolant d'isolation (182).

13. Dispositif semi-conducteur selon l'une quelconque des revendications précédentes,
dans lequel le premier motif isolant d'isolation (181) est espacé de la première région de source/drain (150a) et de la deuxième région de source/drain (150b), et
dans lequel le deuxième motif isolant d'isolation (182) est en contact avec la troisième région de source/drain (150c) et la quatrième région de source/drain (150d).

14. Dispositif semi-conducteur selon la revendication 13, dans lequel une surface inférieure du premier motif isolant d'isolation (181) est à un niveau supérieur à un niveau d'une surface inférieure du deuxième motif isolant d'isolation (182).

15. Dispositif semi-conducteur selon la revendication 13 ou 14,
dans lequel le premier motif isolant d'isolation (181) comprend une pluralité de surfaces latérales présentant des pentes différentes, et
dans lequel le deuxième motif isolant d'isolation (182) comprend des surfaces latérales présentant une pente.
